(19) Europäisches Patentamt
European Patent Office
Office européen des brevets

(11) **EP 2 637 030 A1**

(12) **EUROPÄISCHE PATENTANMELDUNG**

(43) Veröffentlichungstag:
**11.09.2013 Patentblatt 2013/37**

(21) Anmeldenummer: **12158116.9**

(22) Anmeldetag: **05.03.2012**

(51) Int Cl.:
*G01R 31/01* (2006.01)          *G01R 31/34* (2006.01)
*G01R 31/40* (2006.01)          *G01R 31/42* (2006.01)
*H01G 9/14* (2006.01)          *H01G 9/145* (2006.01)
*G01R 27/26* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **ebm-papst Mulfingen GmbH & Co. KG**
**74673 Mulfingen (DE)**

(72) Erfinder:
• **Bürkert, Martin**
  **74677 Dörzbach-Hohebach (DE)**
• **Schmitt, Martin**
  **97922 Lauda-Königshofen (DE)**

• **Hertrich, Alexander**
  **74677 Dörzbach (DE)**
• **Hessel, Leo**
  **74653 Künzelsau (DE)**

(74) Vertreter: **Patentanwälte**
**Dr. Solf & Zapf**
**Candidplatz 15**
**81543 München (DE)**

Bemerkungen:
Ein Antrag gemäss Regel 139 EPÜ auf Berichtigung der Beschreibung liegt vor. Über diesen Antrag wird im Laufe des Verfahrens vor der Prüfungsabteilung eine Entscheidung getroffen (Richtlinien für die Prüfung im EPA, A-V, 3.).

(54) **Verfahren zur Lebensdauer-Überwachung eines Elektrolytkondensators sowie Vorrichtung mit einem entsprechend überwachten Elektrolytkondensator"**

(57) Die vorliegende Erfindung betrifft ein Verfahren zur Lebensdauer-Überwachung mindestens eines Elektrolytkondensators (C) in einer elektrischen Vorrichtung, insbesondere in einer elektronischen Ansteuerschaltung für einen EC-Motor. Zur Erkennung eines nahenden Lebensdauer- und/oder Brauchbarkeitsdauer-Endes des Elektrolytkondensators (C) wird in bestimmten Zeitabständen über die Betriebszeit der Vorrichtung hinweg die im Betrieb der Vorrichtung unter den jeweiligen Betriebsbedingungen vorhandene Impedanz (Z) des Elektrolytkondensators (C) als Ist-Kennwert erfasst und mit einer - als ein vorbestimmter, für die Funktion der Vorrichtung noch ausreichender, abgespeicherter Grenz-Kennwert vorgegebenen - Maximal-Impedanz ($Z_{max}$) verglichen. Alternativ zur Impedanz (Z) kann auch eine entsprechende Erfassung des Elko-Innenwiderstandes (ESR) oder der Rippelspannung ($U_{Rippel}$) oder des Verlustfaktors (tan $\delta$) als maßgebliche Kenngröße erfolgen. In Abhängigkeit von der Größe einer ermittelten Differenz zwischen dem jeweiligen Ist-Kennwert und dem Grenz-Kennwert und bei Erreichen einer vorbestimmten minimal zulässigen Differenz wird ein Warnsignal erzeugt. Weiterhin betrifft die Erfindung eine elektrische Vorrichtung, insbesondere elektronische Ansteuerschaltung für einen EC-Motor, mit mindestens einem Elektrolytkondensator (C) und mit Mitteln zur Durchführung eines solchen Verfahrens.

FIG. 2

**Beschreibung**

Die vorliegende Erfindung betrifft zunächst ein Verfahren zur Lebensdauer-Überwachung mindestens eines Elektrolytkondensators, insbesondere Aluminium-Elektrolytkondensators, in einer elektrischen Vorrichtung, insbesondere in einer elektronischen Ansteuerschaltung für einen elektronisch kommutierten Elektromotor, kurz EC-Motor.

Ferner betrifft die Erfindung auch eine elektrische Vorrichtung, insbesondere in einer Ausgestaltung als elektronische Ansteuerschaltung für einen EC-Motor, mit mindestens einem Elektrolytkondensator.

In elektronischen Schaltungen von bestimmten elektrischen Vorrichtungen werden häufig Aluminium-Elektrolytkondensatoren, kurz Alu-Elkos, als Energiespeicher eingesetzt. Ein großer Nachteil liegt darin, dass ein Alu-Elko während des Betriebes - insbesondere auf Grund einer Verdunstung bzw. Verdampfung seines flüssigen Elektrolytes - einer Alterung unterliegt und daher den hauptsächlichen, die Lebensdauer der Vorrichtung begrenzenden Faktor darstellt. Die Geschwindigkeit der Alterung und damit die zur Verfügung stehende Betriebszeit bis zum Ende der Lebens- bzw. Brauchbarkeitsdauer ist von verschiedenen Parametern abhängig, darunter beispielsweise auch der jeweiligen Umgebungstemperatur und der Strombelastung des Elkos während des Betriebes.

Mittels geeigneter empirischer Formeln kann theoretisch abgeschätzt werden, wann das Ende der Gebrauchsdauer eines Elkos erreicht wird. Da es sich aber um ein rein theoretisch abgeschätztes Gebrauchsdauerende handelt, hat dies nicht zwangsläufig einen unmittelbaren Defekt des Elkos zur Folge. Eine hinreichende Funktion des Elkos in der jeweiligen Vorrichtung und damit auch der Vorrichtung selbst kann grundsätzlich auch dann noch eine bestimmte Zeit gegeben sein. Deshalb ist eine theoretische Lebensdauer-Berechnung für die Praxis zu ungenau.

Das Dokument DE 10 2004 036 211 A1 beschreibt ein Verfahren zur Ermittlung der Alterung eines Elektrolytkondensators. Dabei sollen die tatsächlichen Einsatzbedingungen berücksichtigt werden. Der Elektrolytkondensator wird mittels eines zuschaltbaren Vorladewiderstandes geladen, wobei während eines Vorladevorgangs auf eine bestimmte Weise durch Spannungsmessungen eine Zeitkonstante des Vorladevorgangs berechnet wird, die anschließend mit einer vorbestimmten Zeitkonstante verglichen wird. Eine ermittelte Abweichung wird als Maß für die Alterung des Elektrolytkondensators gewertet.

In dem Dokument DE 10 2004 035 723 A1 sind ein Verfahren und eine Vorrichtung zur Ermittlung einer Restlebensdauer eines Elektrolytkondensators eines Frequenzumrichters beschrieben. Hiernach wird eine Restlebensdauer eines Elektrolytkondensators mit Hilfe seiner berechneten Kerntemperatur und einer korrespondierenden Lebensdauer berechnet. Die Kerntemperatur wird mit Hilfe der gemessenen Umgebungstemperatur und seiner berechneten Verlustleistung bestimmt. Aus der Lebensdauer wird jeweils eine Alterungsgeschwindigkeit berechnet, die zu einem tatsächlichen Lebensalter aufintegriert wird, und die subtrahiert von einem Lebensdauerende die jeweilige Restlebensdauer ergibt. Die Verlustleistung wird in Abhängigkeit von einer gemessenen Zwischenkreisspannung, einem gemessenen Motorstrom, einer ermittelten Motorspannung, der Kapazität des Elkos und in ihm wirksamer Innenwiderstände berechnet. Alles in allem führt dies zu einem großen Rechenaufwand.

Aus der DE 100 21 118 A1 ist ein weiteres Verfahren zum Erfassen des Lebensdauerendes eines elektrischen Gerätes mit Elektrolytkondensator bekannt. Dazu erfolgt im Betrieb unter elektrischer Spannung eine ständige oder wiederholte Messung der Betriebstemperatur des Kondensators, ein Vergleich des jeweiligen Messwerts mit einer vorher ermittelten Kondensator-Betriebstemperatur und eine Auswertung des Vergleichsergebnisses zum Erkennen eines etwaigen Anstieges der Betriebstemperatur, der einem Anstieg der Ausfallrate bzw. einer Verkürzung der Lebensdauer entspricht.

Schließlich betrifft das Dokument DE 10 2004 052 977 A1 ein weiteres Diagnoseverfahren zum Bestimmen des Alterungszustandes eines Kondensators. Dabei werden jeweils mehrere alterungsabhängige Parameter des Kondensators durch verschiedene Entladungsvorgänge gemessen.

Der vorliegenden Erfindung liegt die Aufgabe zu Grunde, eine einfach und kostengünstig realisierbare Lebensdauer-Überwachung eines Elektrolytkondensators im laufenden Betrieb mit größerer Genauigkeit und unter Berücksichtigung der tatsächlichen Betriebsbedingungen zu ermöglichen.

Diese Aufgabe wird durch ein Verfahren mit den Merkmalen jedes unabhängigen Anspruchs 1, 3, 5 oder 8 gelöst. Bevorzugte Ausgestaltungsmaßnahmen sind in den jeweils abhängigen Ansprüchen enthalten.

Eine elektrische Vorrichtung gemäß dem unabhängigen Anspruch 9 ist durch Mittel zur Durchführung des erfindungsgemäßen Verfahrens gekennzeichnet. Weitere vorteilhafte Ausgestaltungsmerkmale sind in den abhängigen Ansprüchen 10 bis 14 enthalten.

Zudem ergeben sich weitere Besonderheiten und erfindungswesentliche Einzelheiten aus der nachfolgenden Beschreibung.

Eine erste Lösung der Aufgabe besteht demnach gemäß dem unabhängigen Anspruch 1 darin, dass zur Erkennung eines nahenden Lebensdauer- und/oder Brauchbarkeitsdauer-Endes des Elektrolytkondensators in bestimmten Zeitabständen, und zwar bevorzugt periodisch in gleichen Zeitabständen, über die Betriebszeit der Vorrichtung hinweg die im Betrieb der Vorrichtung unter den jeweiligen Betriebsbedingungen vorhandene Impedanz des Elektrolytkondensators als Ist-Kennwert erfasst und mit einer - als ein vorbestimmter, für die Funktion der Vorrichtung noch ausreichender, abgespeicherter Grenz-Kennwert vorgegebenen - Maximal-Impedanz verglichen wird, wobei in Abhängigkeit von der Größe einer ermittelten Differenz zwischen dem jeweiligen Ist-Kennwert und dem Grenz-Kennwert und bei Erreichen einer vorbestimmten minimal zulässigen Differenz ein Warnsignal erzeugt wird.

Dieser erfindungsgemäßen Lösung liegt die Erkenntnis zu Grunde, dass bei einem Aluminium-Elektrolytkondensator mit fortschreitender Alterung die Impedanz deutlich - und daher sehr gut messbar - zunimmt. Die Veränderung der Impedanz liegt um zwei Zehnerpotenzen über der Veränderung der Kapazität. Daher kann an Hand der Impedanz vorteilhafterweise eine sehr viel genauere Aussage über den tatsächlichen Alterungszustand des Elektrolytkondensators gemacht werden als z. B. über seine Kapazität. Dadurch kann auch ein nahendes Lebensdauerende oder zumindest Brauchbarkeitsdauerende genauer und sicherer bestimmt werden. Zudem ist ohnehin die Impedanz der bestimmende Faktor für die korrekte Funktion innerhalb der jeweiligen elektrischen Vorrichtung.

Die Impedanz kann vorteilhafterweise im Betrieb der Vorrichtung auf einfache Weise mittelbar durch Messung einer an dem Elektrolytkondensator auftretenden Rippelspannung und eines zugehörigen Rippelstromes erfasst und nach der Beziehung $Z = \dfrac{U_{Rippel}}{I_{Rippel}}$ . bestimmt werden.

Eine Überwachung und Auswertung der Impedanz gibt vorteilhafterweise mittelbar auch Aufschluss über den Kondensator-Innenwiderstand ESR und seine Kapazität C, und zwar auf Grund der bekannten Beziehung

$$Z = \sqrt{ESR^2 + \left(\frac{1}{j\omega C}\right)^2} \ .$$

Weitere Einzelheiten zur Messung bzw. Bestimmung der Impedanz werden in der nachfolgenden Beschreibung noch erläutert werden.

Die obige, der Erfindung zu Grunde liegende Aufgabe wird außerdem durch jeden der unabhängigen Ansprüche 3, 5 und 8 gelöst. Die darin definierten Verfahren entsprechen zunächst weitgehend dem Verfahren gemäß Anspruch 1.

Gemäß dem Anspruch 3 wird lediglich - anstatt der Impedanz - alternativ der Innenwiderstand ESR des Elektrolytkondensators als Ist-Kennwert erfasst und mit einem vorgegebenen Grenz-Widerstand verglichen. Da der Innenwiderstand ESR eines Alu-Elkos temperaturabhängig ist und sich dieser Einfluss vor allem bei Temperaturen unter 0 ° C bemerkbar macht, wird implizit auch die Temperatur miterfasst und berücksichtigt.

Eine weitere Vereinfachung ergibt sich, wenn gemäß dem unabhängigen Anspruch 5 für die Bestimmung des Lebensdauerendes alternativ nur die Höhe des am Elektrolytkondensator entstehenden Spannungsrippels bzw. der Rippelspannung zu Grunde gelegt wird. Abhängig von derjeweiligen Vorrichtung darf die Rippelspannung einen bestimmten maximalen Wert zwar unterschreiten, aber nie überschreiten, damit die Funktion der Vorrichtung gegeben ist. Bei Überschreiten der für die Vorrichtung charakteristischen maximalen Rippelspannung ist das Lebensdauerende erreicht.

Weiterhin kann gemäß dem unabhängigen Anspruch 8 alternativ auch der Verlustfaktor tan $\delta$ als Kriterium für das Lebensdauerende ausgewertet werden.

Anhand der Zeichnungen soll die Erfindung im Folgenden beispielhaft genauer erläutert werden. Es zeigen:

Fig. 1     ein vereinfachtes Ersatzschaltbild eines Elektrolytkondensators zusammen mit einem zugehörigen Zeigerdiagramm in der komplexen Ebene,

Fig. 2     ein Blockschaltbild einer Messanordnung zur Erfassung und Auswertung von Kennwerten des Elektrolytkondensators und

Fig. 3     ein weiteres Schaltbild der Messanordnung in einer Ausführung speziell zur Erfassung der Kondensator-Rippelspannung.

In den verschiedenen Figuren der Zeichnung sind gleiche bzw. sich entsprechende Teile und Komponenten stets mit den gleichen Bezugszeichen versehen.

Zu der anschließenden Beschreibung wird ausdrücklich betont, dass die Erfindung nicht auf die Ausführungsbeispiele und dabei nicht auf alle oder mehrere Merkmale von beschriebenen Merkmalskombinationen beschränkt ist, vielmehr kann jedes einzelne Teilmerkmal des/jedes Ausführungsbeispiels auch losgelöst von allen anderen im Zusammenhang damit beschriebenen Teilmerkmalen für sich und auch in Kombination mit beliebigen Merkmalen eines anderen Ausführungsbeispiels sowie auch unabhängig von den Merkmalskombinationen und Rückbeziehungen der Ansprüche eine erfinderische Bedeutung haben.

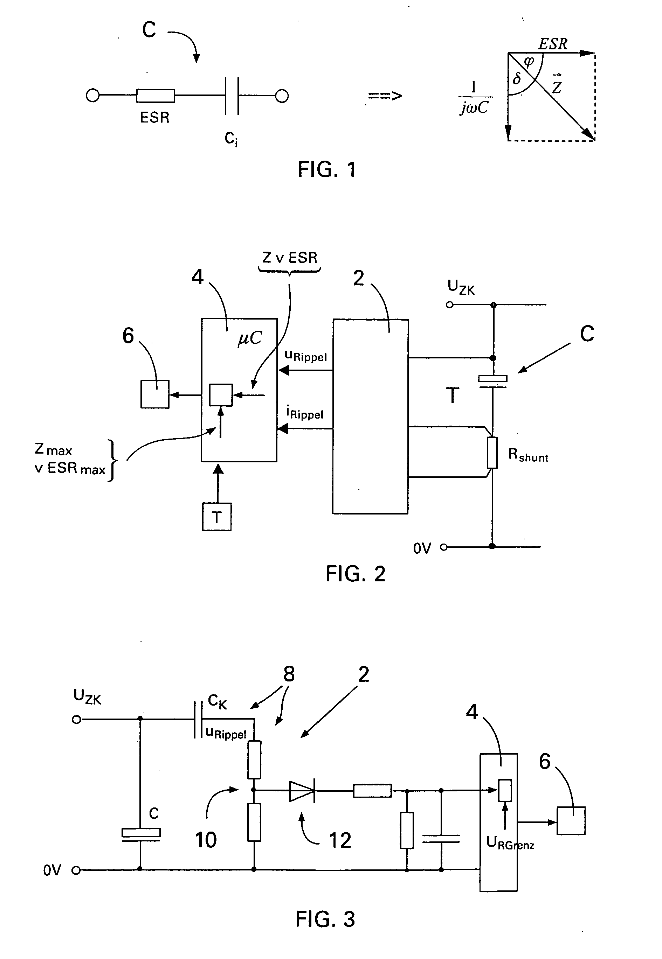

Zur grundsätzlichen Erläuterung ist in Fig. 1 ein vereinfachtes Serien-Ersatzschaltbild eines Elektrolytkondensators C mit seiner idealen Kapazität $C_i$ und seinem Ohm'schen Widerstand ESR (englisch: Equivalent Series Resistance = äquivalenter Serienwiderstand) dargestellt, wobei eine Induktivität ESL vernachlässigt wird und daher nicht dargestellt ist. Zudem ist in Fig. 1 das zugehörige Zeigerdiagramm dargestellt. Durch den parasitären Ohm'schen Verlust ESR beträgt eine Phasenverschiebung nicht genau 90 °, sondern ist um den sogenannten Verlustwinkel δ reduziert. Dieser Winkel wird als Tangens ausgedrückt und heißt dann Verlustfaktor tan δ. Er ergibt sich aus dem Tangens des Phasenwinkels δ zwischen der geometrischen Summe der Blindwiderstände und dem Ersatzreihenwiderstand ESR. Unter Vernachlässigung der Induktivität ESL sind der Verlustfaktor tan δ, der ESR und die Kapazität C eines Kondensators bei einer bestimmten Frequenz f mit folgender Formel miteinander verbunden: $\tan δ = ESR \cdot \omega C$, mit w = 2πf.

Der wichtigste, für eine korrekte Funktion eines Elektrolytkondensators innerhalb einer elektrischen Vorrichtung bestimmende Faktor ist die Impedanz Z (Scheinwiderstand). Die Impedanz Z ist in einem rechtwinkligen Dreieck die Hypotenuse und kann berechnet werden als Wurzel der Quadrate aus der realen Größe ESR und der imaginären Größe ESR und Z schließen dabei in diesem Dreieck einen Winkel φ ein (siehe das Zeigerdiagramm in Fig. 1). Es gilt daher die Beziehung:

$$Z = \sqrt{ESR^2 + \left(\frac{1}{j\omega C}\right)^2}.$$

In Fig. 2 ist ein Elektrolytkondensator C als Bestandteil einer nicht weiter dargestellten elektrischen Vorrichtung bzw. Schaltung dargestellt. Bei der Vorrichtung handelt es sich insbesondere um eine Ansteuerschaltung für einen EC-Motor, wobei eine Netzwechselspannung zu einer Zwischenkreis-Gleichspannung $U_{ZK}$ gleichgerichtet wird, aus der über einen gesteuerten Wechselrichter eine Motor-Betriebswechselspannung generiert wird. Der Elektrolytkondensator C dient dabei zur Glättung der Zwischenkreis-Gleichspannung $U_{ZK}$. Die Erfindung ist allerdings nicht auf diese spezielle Anwendung beschränkt. Zur Erfassung bestimmter Kennwerte des Elektrolytkondensators C ist eine Messschaltung 2 vorgesehen, und zur Verarbeitung und Auswertung der Kennwerte eine Recheneinrichtung 4, wobei die zweckmäßig von einem Mikrocontroller μC gebildete Recheneinrichtung 4 anhand der jeweiligen Auswertung ein nahendes Ende der Lebensdauer oder Brauchbarkeitsdauer des Elektrolytkondensators C feststellt und dann eine Signaleinrichtung 6 zur Ausgabe eines akustischen und/oder optischen Warnsignals ansteuert, wobei das Warnsignal als Service-Meldung signalisieren soll, dass der Elektrolytkondensator C voraussichtlich kurzfristig ausfallen wird. Der Anwender kann sich daher frühzeitig um einen Ersatz kümmern, was somit Ausfallzeiten der Vorrichtung reduziert oder gänzlich vermeidet.

In einer ersten, bevorzugten Ausführung der Erfindung wird während des Betriebs der Vorrichtung in bestimmten, unregelmäßigen, insbesondere aber regelmäßigen, periodischen Zeitabständen die im Betrieb jeweils vorhandene Impedanz Z des Elektrolytkondensators C über die Messschaltung 2 im Zusammenwirken mit der Recheneinrichtung 4 als Ist-Kennwert erfasst und in der Recheneinrichtung 4 mit einer Maximal-Impedanz $Z_{max}$ verglichen. Diese Maximal-Impedanz $Z_{max}$ wird zuvor als Grenz-Kennwert vorgegeben, beispielsweise empirisch ermittelt, und gespeichert, wobei die Maximal-Impedanz ein Wert ist, der noch grade für eine ordnungsgemäße Funktion der elektrischen Vorrichtung ausreicht. Die tatsächliche Impedanz Z darf - abhängig von der jeweiligen Vorrichtung - einen bestimmten Wert zwar unterschreiten, aber nie überschreiten. Durch einen einfachen Versuch oder eine Messung im Labor kann die - für die jeweilige Vorrichtung typische - Maximal-Impedanz $Z_{max}$ ermittelt werden. Dieser Wert wird in der Recheneinrichtung 4 abgelegt und periodisch mit dem tatsächlichen Wert der Impedanz Z des Aluminium- Elektrolytkondensators C verglichen. Dadurch kann zu jedem Zeitpunkt bestimmt werden, in welchem Stadium sich der Elektrolytkondensator C hinsichtlich seiner Alterung momentan befindet. Unter Berücksichtigung einer durch Versuche für den jeweiligen Kondensator bekannten Alterungsfunktion der Impedanz Z und einer Temperaturabhängigkeit ist durch die Erfindung eine Vorhersage der verbleibenden Lebensdauer möglich. Damit ist die Recheneinrichtung 4 ebenfalls in der Lage, bei Erreichen einer zuvor definierten Restlebensdauer eine Servicemeldung auszugeben.

Die Impedanz Z an sich besitzt neben einer Temperaturabhängigkeit auch eine Frequenzabhängigkeit. Jedoch haben diese Abhängigkeiten bei dem erfindungsgemäßen Verfahren keinen Einfluss, da die Bedingung $Z < Z_{max}$ bereits die Temperatur- und Frequenzabhängigkeit einschließt.

Wie sich aus Fig. 2 ergibt, wird zur Erfassung der Impedanz Z eine an dem Elektrolytkondensator C auftretende Rippelspannung $U_{Rippel}$ gemessen. Außerdem wird ein zugehöriger Rippelstrom $i_{Rippel}$ erfasst, und zwar mittelbar über einen Spannungsabfall an einem niederohmigen Messwiderstand $R_{Shunt}$, der in Reihe zu dem Elektrolytkondensator C geschaltet ist. Die Recheneinrichtung 4 berechnet zunächst die Effektivwerte $U_{Rippel}$ und $I_{Rippel}$ und anschließend die jeweilige Impedanz Z nach der Formel $Z = \dfrac{U_{Rippel}}{I_{Rippel}}$ .

Zusätzlich werden dabei auch die Temperatur T und die Frequenz f berücksichtigt.

In einer alternativen Ausführung der Erfindung wird zur Überwachung der Lebensdauer des Elektrolytkondensators C anstatt seiner Impedanz Z dessen Innenwiderstand ESR erfasst. Auch dabei wird dann der Recheneinrichtung 4 ein bestimmter Grenzwert vorgegeben, so dass in der Darstellung gemäß Fig. 2 innerhalb der Recheneinrichtung 4 lediglich die Werte Z und $Z_{max}$ gegen ESR und $ESR_{Grenz}$ auszutauschen sind. Deshalb sind in Fig. 2 beide Alternativen angegeben: "Z v ESR" und "$Z_{max}$ v $ESR_{max}$", wobei der Operator "v" für "oder" steht. Zur Bestimmung des Innenwiderstandes ESR werden der Momentanwert der Rippelspannung $u_{Rippel}$ und der Momentanwert des Kondensatorstroms $i_{Rippel}$ gemessen. Aus diesen Werten wird die momentane Verlustleistung am Innenwiderstand ESR und an dem in Reihe geschalteten Messwiderstand $R_{Shunt}$ bestimmt. Aus der Summe mehrerer solcher Leistungsmessungen wird dann ein Mittelwert der Leistung $P_{Mittel}$ über die Summe der Widerstände ESR + $R_{Shunt}$ ermittelt. Zusätzlich wird aus dem gemessenen Kondensatorstrom $i_{Rippel}$ der Effektivstrom $I_{Rippel}$ bestimmt. Mit diesen Werten lässt sich der Innenwiderstand ESR nach folgender Gleichung berechnen:

$$R_{ESR} = R_{wirk} - R_{Shunt} = \frac{P_{Mittel}}{I_{Rippel}^2} - R_{Shunt} \, .$$

Der Effektivwert $I_{Rippel}$ des Kondensator- bzw. Rippelstroms $i_{Rippel}$ berechnet sich allgemein aus:

$$I_{Rippel} = \sqrt{\frac{1}{T} \int_o^T i_{Rippel}(t)\, dt}$$

mit T= Periodendauer, und speziell für sinusförmige Funktionen gilt:

$$I_{Rippel} = \frac{\hat{i}_{Rippel}}{\sqrt{2}}.$$

Beide Möglichkeiten können in der Recheneinrichtung 4 umgesetzt werden.

Da der Innenwiderstand ESR - wie auch die Impedanz Z - temperaturabhängig ist und sich dieser Einfluss vor allem bei Temperaturen unter 0 ° C bemerkbar macht, wird die besagte Temperatur T von der Recheneinrichtung 4 ebenfalls erfasst und berücksichtigt.

Das erfindungsgemäße Verfahren kann alternativ auch dahingehend abgewandelt werden, dass zur Überwachung der Lebensdauer ausschließlich die am Elektrolytkondensator C anstehende Rippelspannung $U_{Rippel}$ erfasst und ausgewertet wird. Dies ist in Fig. 3 veranschaulicht. Die erfasste Rippelspannung $U_{Rippel}$ wird in der Recheneinrichtung 4 mit einem entsprechend den Anforderungen der jeweiligen elektrischen Vorrichtung vorgegebenen Referenzwert $U_{RGrenz}$ verglichen. Die Rippelspannung $u_{Rippel}$ wird über eine Filterschaltung 8 mit einem Auskoppelkondensator $C_K$, einem Spannungsteiler 10 und einem Spitzenwertgleichrichter 12 aufbereitet und gefiltert, und dieses so erfasste Signal wird der Recheneinrichtung 4 zugeführt.

In einer weiteren Alternative der Erfindung wird der eingangs erwähnte Verlustfaktor tan $\delta$ als Kriterium für die Überwachung der Lebensdauer verwendet. Der Verlustfaktor ergibt sich aus der Beziehung tan $\delta = ESR \cdot \omega C$. Dies

bedeutet, dass in der Darstellung gemäß Fig. 2 innerhalb der Recheneinrichtung 4 die Kennwerte Z und $Z_{max}$ bzw. ESR und $ESR_{max}$ durch $\tan \delta$ und $\tan \delta_{Grenz}$ zu ersetzen wären.

Abkürzungsverzeichnis

$U_{Rippel}$     - Effektivwert der Rippelspannung

$U_{Rippel}$     - Momentanwert der Rippelspannung

$I_{Rippel}$     - Effektivwert des Rippelstroms

$i_{Rippel}$     - Momentanwert des Rippelstroms

Kondensatorstrom = Rippelstrom

Die Erfindung führt zu besonderen Vorteilen. Vor allem die in Fig. 2 veranschaulichte, bevorzugte Ausführung mit Überwachung der Impedanz Z führt zu einer hohen Genauigkeit der Feststellung eines nahenden Lebensdauer-Endes des Elektrolytkondensators C, weil die prozentuale Änderung der Impedanz Z etwa zwei Zehnerpotenzen höher als diejenige der Kapazität ist und damit genauer und sicherer ermittelt werden kann. Weiterhin basiert die Erfindung nicht auf empirischen Formeln der Hersteller zur Gebrauchsdauerberechnung, sondern auf Messungen des tatsächlichen Zustandes des Elektrolytkondensators C. Wie bereits erläutert wurde, bedeutet das Ende der Gebrauchsdauer nicht automatisch einen Defekt des Elkos. Im Gegensatz zu einer empirischen Lebensdauerabschätzung können somit erfindungsgemäß auch individuelle Herstellerreserven oder Bauteilstreuungen positiv für die Gesamtlebensdauer bzw. Gesamt-Gebrauchsdauer der jeweiligen Vorrichtung ausgenutzt werden. Zudem kann erfindungsgemäß eine Bestimmung der Alterung auch während des regulären Betriebes der Vorrichtung erfolgen. Dies bedeutet, dass die jeweilige Vorrichtung für einen Messvorgang nicht aus- und wieder eingeschaltet zu werden braucht.

Vorsorglich sei erwähnt, dass sich die Erfindung natürlich auch für solche Vorrichtungen eignet, in denen sich mehrere Elektrolytkondensatoren befinden. Das erfindungsgemäße Verfahren ist somit für alle elektronischen Schaltungen mit integrierten Aluminium-Elektrolytkondensatoren anwendbar.

Die Erfindung ist nicht auf die dargestellten und beschriebenen Ausführungsbeispiele beschränkt, sondern umfasst auch alle im Sinne der Erfindung gleichwirkenden Ausführungen. Es wird ausdrücklich betont, dass die Ausführungsbeispiele nicht auf alle Merkmale in Kombination beschränkt sind, vielmehr kann jedes einzelne Teilmerkmal auch losgelöst von allen anderen Teilmerkmalen für sich eine erfinderische Bedeutung haben. Ferner ist die Erfindung bislang auch noch nicht auf die im jeweiligen unabhängigen Anspruch definierte Merkmalskombination beschränkt, sondern kann auch durch jede beliebige andere Kombination von bestimmten Merkmalen aller insgesamt offenbarten Einzelmerkmalen definiert sein. Dies bedeutet, dass grundsätzlich praktisch jedes Einzelmerkmal des jeweiligen unabhängigen Anspruchs weggelassen bzw. durch mindestens ein an anderer Stelle der Anmeldung offenbartes Einzelmerkmal ersetzt werden kann. Insofern sind die Ansprüche lediglich als ein erster Formulierungsversuch für eine Erfindung zu verstehen.

**Patentansprüche**

1. Verfahren zur Lebensdauer-Überwachung mindestens eines Elektrolytkondensators (C) in einer elektrischen Vorrichtung, insbesondere in einer elektronischen Ansteuerschaltung für einen EC-Motor,
**dadurch gekennzeichnet, dass** zur Erkennung eines nahenden Lebensdauer- und/oder Brauchbarkeitsdauer-Endes des Elektrolytkondensators (C) in bestimmten Zeitabständen über die Betriebszeit der Vorrichtung hinweg die im Betrieb der Vorrichtung unter den jeweiligen Betriebsbedingungen vorhandene Impedanz (Z) des Elektrolytkondensators (C) als Ist-Kennwert erfasst und mit einer - als ein vorbestimmter, für die Funktion der Vorrichtung noch ausreichender, abgespeicherter Grenz-Kennwert vorgegebenen - Maximal-Impedanz ($Z_{max}$) verglichen wird, wobei in Abhängigkeit von der Größe einer ermittelten Differenz zwischen dem jeweiligen Ist-Kennwert (Z) und dem Grenz-Kennwert ($Z_{max}$) und bei Erreichen einer vorbestimmten minimal zulässigen Differenz ein Warnsignal erzeugt wird.

2. Verfahren nach Anspruch 1,
**dadurch gekennzeichnet, dass** die Impedanz (Z) im Betrieb der Vorrichtung mittelbar durch Messung einer an dem Elektrolytkondensator (C) auftretenden Rippelspannung (u$_{Rippel}$) und eines zugehörigen Rippelstromes (i$_{Rippel}$) und durch Bildung der zugehörigen Effektivwerte (U$_{Rippel}$ und I$_{Rippel}$) nach der Formel $Z = \dfrac{U_{Rippel}}{I_{Rippel}}$ bestimmt wird.

**3.** Verfahren nach dem Oberbegriff des Anspruchs 1,
**dadurch gekennzeichnet, dass** zur Erkennung eines nahenden Lebensdauer- und/oder Brauchbarkeitsdauer-Endes des Elektrolytkondensators (C) in bestimmten Zeitabständen über die Betriebszeit hinweg der Innenwiderstand (ESR) des Elektrolytkondensators (C) als Ist-Kennwert erfasst und mit einem - als ein vorbestimmter, für die Funktion der Vorrichtung noch ausreichender, abgespeicherter Grenz-Kennwert vorgegebenen - Grenzwiderstand (ESR$_{Grenz}$) verglichen wird, wobei in Abhängigkeit von der Größe einer ermittelten Differenz zwischen dem jeweiligen Ist-Kennwert (ESR) und dem Grenz-Kennwert (ESR$_{Grenz}$) und bei Erreichen einer vorbestimmten minimal zulässigen Differenz ein Warnsignal erzeugt wird.

**4.** Verfahren nach Anspruch 3,
**dadurch gekennzeichnet, dass** der Innenwiderstand (ESR) im Betrieb der Vorrichtung bestimmt wird, indem eine an dem Elektrolytkondensator (C) auftretende Rippelspannung (u$_{Rippel}$) und ein zugehöriger Kondensatorstrom (i$_{Rippel}$) gemessen werden, wobei durch Multiplikation dieser Werte eine momentane, an dem Innenwiderstand (ESR) und einem in Reihe zu dem Elektrolytkondensator (C) liegenden Messwiderstand (R$_{Shunt}$) umgesetzte Verlustleistung (P) und daraus insbesondere ein Mittelwert (P$_{mittel}$) über mehrere Messungen bestimmt wird, wobei aus dem gemessenen Kondensatorstrom (i$_{Rippel}$) ein Effektivstrom (I$_{Rippel}$) ermittelt wird, und wobei der Innenwiderstand (ESR) nach folgender Gleichung berechnet wird:

$$R_{ESR} = R_{wirk} - R_{Shunt} = \frac{P_{Mittel}^{.}}{I_{Rippel}^{2}} - R_{Shunt} \; .$$

**5.** Verfahren nach dem Oberbegriff des Anspruchs 1,
**dadurch gekennzeichnet, dass** zur Erkennung eines nahenden Lebensdauer- und/oder Brauchbarkeitsdauer-Endes des Elektrolytkondensators (C) in bestimmten Zeitabständen über die Betriebszeit der Vorrichtung hinweg die im Betrieb der Vorrichtung unter den jeweiligen Betriebsbedingungen vorhandene Rippelspannung (U$_{Rippel}$) an dem Elektrolytkondensator (C) als Ist-Kennwert erfasst und mit einer - als ein vorbestimmter, für eine Funktion der Vorrichtung noch ausreichender, abgespeicherter Grenz-Kennwert vorgegebenen - Maximal-Rippelspannung (U$_{Rmax}$) verglichen wird, wobei in Abhängigkeit von der Größe einer ermittelten Differenz zwischen dem jeweiligen Ist-Kennwert (U$_{Rippel}$) und dem Grenz-Kennwert (U$_{Rmax}$) und bei Erreichen einer vorbestimmten minimal zulässigen Differenz ein Warnsignal erzeugt wird.

**6.** Verfahren nach einem der Ansprüche 2 bis 5,
**dadurch gekennzeichnet, dass** die Rippelspannung (u$_{Rippel}$) über eine Filterschaltung (9) mit Spitzenwertgleichrichter (12) und Spannungsteiler (10) aufbereitet und einer Recheneinrichtung (4) zugeführt wird.

**7.** Verfahren nach einem der Ansprüche 2 bis 6,
**dadurch gekennzeichnet, dass** der Rippel- bzw. Kondensatorstrom (i$_{Rippel}$) über einen in Reihe zu dem Elektrolytkondensator (C) geschalteten Messwiderstand (R$_{Shunt}$) erfasst wird.

**8.** Verfahren nach dem Oberbegriff des Anspruchs 1,
**dadurch gekennzeichnet, dass** zur Erkennung eines nahenden Lebensdauer- und/oder Brauchbarkeitsdauer-Endes des Elektrolytkondensators (C) in bestimmten Zeitabständen über die Betriebszeit der Vorrichtung hinweg der im Betrieb der Vorrichtung unter den jeweiligen Betriebsbedingungen vorhandene Verlustfaktor (tan δ) des Elektrolytkondensators (C) als Ist-Kennwert erfasst und mit einem - als ein vorbestimmter, für die Funktion der Vorrichtung noch ausreichender, abgespeicherter Grenz-Kennwert vorgegebenen - Grenz-Verlustfaktor (tan δ$_{Grenz}$) verglichen wird, wobei in Abhängigkeit von der Größe einer ermittelten Differenz zwischen dem jeweiligen Ist-Kennwert (tan δ) und dem Grenz-Kennwert (tan δ$_{Grenz}$) und bei Erreichen einer vorbestimmten minimal zulässigen Differenz ein Warnsignal erzeugt wird.

9. Elektrische Vorrichtung, insbesondere elektronische Ansteuerschaltung für einen EC-Motor, mit mindestens einem Elektrolytkondensator (C), **gekennzeichnet durch** Mittel zur Durchführung des Verfahrens nach einem der Ansprüche 1 bis 8.

10. Vorrichtung nach Anspruch 9,
    **gekennzeichnet durch** eine Messschaltung (2) zum Erfassen des/jedes zu überwachenden Ist-Kennwertes, einem Speicher zum Abspeichern des zugehörigen vorbestimmten Grenz-Kennwertes sowie eine Recheneinrichtung (4) zur Auswertung der Kennwerte.

11. Vorrichtung nach Anspruch 10,
    **dadurch gekennzeichnet, dass** die Recheneinrichtung (4) ein Mikrocontroller ($\mu$C) ist.

12. Vorrichtung nach einem der Ansprüche 9 bis 11,
    **dadurch gekennzeichnet, dass** eine an dem Elektrolytkondensator (C) auftretende Rippelspannung ($u_{Rippel}$) über eine Filterschaltung (8) mit Spannungsteiler (10) und Spitzenwert-Gleichrichter (12) ausgekoppelt und der Recheneinrichtung (4) zugeführt wird.

13. Vorrichtung nach einem der Ansprüche 9 bis 12,
    **dadurch gekennzeichnet, dass** ein Kondensatorstrom ($i_{Rippel}$) über einen in Reihe zu dem Elektrolytkondensator (C) geschalteten Messwiderstand ($R_{Shunt}$) erfasst wird.

14. Vorrichtung nach einem der Ansprüche 9 bis 13,
    **gekennzeichnet durch** eine von der Recheneinrichtung (4) ansteuerbare Signaleinrichtung (6) zur Erzeugung eines optischen und/oder akustischen Signals im Falle eines festgestellten bevorstehenden Lebens- oder Brauchbarkeitsdauer-Endes des Elektrolytkondensators (C).

FIG. 1

FIG. 2

FIG. 3

| | Europäisches Patentamt European Patent Office Office européen des brevets | **EUROPÄISCHER RECHERCHENBERICHT** | **Nummer der Anmeldung** EP 12 15 8116 |
|---|---|---|---|

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2010/161259 A1 (KIM DEUK SOO [KR] ET AL) 24. Juni 2010 (2010-06-24) * Zusammenfassung * * Seite 3, Absatz [0037] - Seite 8, Absatz [00108]; Abbildungen 1-8 * * Ansprüche 8-14, 18-25 * ----- | 1-14 | INV. G01R31/01 G01R31/34 G01R31/40 G01R31/42 H01G9/14 H01G9/145 G01R27/26 |
| X | KR 2009 0105773 A (POWERTRON ENG CO LTD) 7. Oktober 2009 (2009-10-07) * Zusammenfassung * * Absatz [[0126]] - Absatz [[0149]]; Abbildungen 1-11 * ----- | 1-14 | |
| X | JP 2002 267708 A (TOSHIBA CORP) 18. September 2002 (2002-09-18) * das ganze Dokument * ----- | 1-14 | |
| X | KR 2010 0120056 A (SON JIN GEUN [KR]) 12. November 2010 (2010-11-12) * das ganze Dokument * ----- | 1-14 | |
| X | MARKUS A VOGELSBERGER ET AL: "Life-Cycle Monitoring and Voltage-Managing Unit for DC-Link Electrolytic Capacitors in PWM Converters", IEEE TRANSACTIONS ON POWER ELECTRONICS, IEEE SERVICE CENTER, PISCATAWAY, NJ, US, Bd. 26, Nr. 2, 1. Februar 2011 (2011-02-01), Seiten 493-503, XP011334719, ISSN: 0885-8993, DOI: 10.1109/TPEL.2010.2059713 * das ganze Dokument * ----- -/-- | 1-14 | **RECHERCHIERTE SACHGEBIETE (IPC)** G01R H01G |

Der vorliegende Recherchenbericht wurde für alle Patentansprüche erstellt

| Recherchenort | Abschlußdatum der Recherche | Prüfer |
|---|---|---|
| München | 13. August 2012 | Bergado Colina, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
..................................................................
& : Mitglied der gleichen Patentfamilie, übereinstimmendes Dokument

EPO FORM 1503 03.82 (P04C03)

Europäisches
Patentamt

European
Patent Office

Office européen
des brevets

# EUROPÄISCHER RECHERCHENBERICHT

**Nummer der Anmeldung**

EP 12 15 8116

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JASON M ANDERSON ET AL: "An on-line fault diagnosis method for power electronic drives", ELECTRIC SHIP TECHNOLOGIES SYMPOSIUM (ESTS), 2011 IEEE, IEEE, 10. April 2011 (2011-04-10), Seiten 492-497, XP031869728, DOI: 10.1109/ESTS.2011.5770922 ISBN: 978-1-4244-9272-5 * Zusammenfassung * * Seite 493 - Seite 494 * ----- | 1-14 | |
| X | AELOIZA ET AL: "A Real Time Method to Estimate Electrolytic Capacitor Condition in PWM Adjustable Speed Drives and Uninterruptible Power Supplies", POWER ELECTRONICS SPECIALISTS CONFERENCE, 2005. PESC '05. IEEE 36TH, IEEE, PISCATAWAY, NJ, USA, 1. Januar 2005 (2005-01-01), Seiten 2867-2872, XP031000530, DOI: 10.1109/PESC.2005.1582040 ISBN: 978-0-7803-9033-1 * das ganze Dokument * ----- | 1-14 | |
| X | MADDULA ET AL: "Lifetime of Electrolytic Capacitors in Regenerative Induction Motor Drives", POWER ELECTRONICS SPECIALISTS CONFERENCE, 2005. PESC '05. IEEE 36TH, IEEE, PISCATAWAY, NJ, USA, 1. Januar 2005 (2005-01-01), Seiten 153-159, XP031000172, DOI: 10.1109/PESC.2005.1581617 ISBN: 978-0-7803-9033-1 * das ganze Dokument * ----- -/-- | 1-14 | **RECHERCHIERTE SACHGEBIETE (IPC)** |

Der vorliegende Recherchenbericht wurde für alle Patentansprüche erstellt

| Recherchenort | Abschlußdatum der Recherche | Prüfer |
|---|---|---|
| München | 13. August 2012 | Bergado Colina, J |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
    .........................................................................................
& : Mitglied der gleichen Patentfamilie, übereinstimmendes
    Dokument

Europäisches
Patentamt

European
Patent Office

Office européen
des brevets

**EUROPÄISCHER RECHERCHENBERICHT**

Nummer der Anmeldung

EP 12 15 8116

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | PANG H M ET AL: "A life prediction scheme for electrolytic capacitors in power converters without current sensor", APPLIED POWER ELECTRONICS CONFERENCE AND EXPOSITION (APEC), 2010 TWENTY-FIFTH ANNUAL IEEE, IEEE, PISCATAWAY, NJ, USA, 21. Februar 2010 (2010-02-21), Seiten 973-979, XP031649584, ISBN: 978-1-4244-4782-4 * das ganze Dokument * ----- | 1-14 | |
| X | GUSTAVO MALAGONI BUIATTI ET AL: "An Online and Noninvasive Technique for the Condition Monitoring of Capacitors in Boost Converters", IEEE TRANSACTIONS ON INSTRUMENTATION AND MEASUREMENT, IEEE SERVICE CENTER, PISCATAWAY, NJ, US, Bd. 59, Nr. 8, 1. August 2010 (2010-08-01), Seiten 2134-2143, XP011296546, ISSN: 0018-9456 * das ganze Dokument * ----- | 1-14 | |
| X A | JP 2008 224533 A (YASKAWA ELECTRIC CORP) 25. September 2008 (2008-09-25) * das ganze Dokument * ----- | 1,2,5-14 3,4 | RECHERCHIERTE SACHGEBIETE (IPC) |
| X A | EP 2 177 923 A1 (PANASONIC ELEC WORKS CO LTD [JP]) 21. April 2010 (2010-04-21) * Zusammenfassung * * Seite 5, Absatz [0035] - Seite 8, Absatz [0084]; Abbildungen 1-9 * ----- | 5-7,9-14 1-4,8 | |
| X A | JP 7 222436 A (MEIDENSHA ELECTRIC MFG CO LTD) 18. August 1995 (1995-08-18) * Zusammenfassung; Abbildungen 1-5 * ----- | 5-7,9-14 1-4,8 | |
| | -/-- | | |

Der vorliegende Recherchenbericht wurde für alle Patentansprüche erstellt

| Recherchenort | Abschlußdatum der Recherche | Prüfer |
|---|---|---|
| München | 13. August 2012 | Bergado Colina, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.................................................................
& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 12 15 8116

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | DE 10 2004 035723 A1 (SIEMENS AG [DE]) 16. Februar 2006 (2006-02-16) | 3,4,9-14 | |
| A | * Zusammenfassung * * Seite 4, Absatz [0023] - Seite 7, Absatz [0037]; Abbildungen 1-5 * ----- | 1,2,5-8 | |
| X | ACACIO M R AMARAL ET AL: "State condition estimation of aluminum electrolytic capacitors used on the primary side of ATX power supplies", IECON 2009 - 35TH ANNUAL CONFERENCE OF IEEE INDUSTRIAL ELECTRONICS (IECON 2009) - 3-5 NOV. 2009 - PORTO, PORTUGAL, IEEE, PISCATAWAY, NJ, USA, 3. November 2009 (2009-11-03), Seiten 442-447, XP031629613, ISBN: 978-1-4244-4648-3 | 3,4,9-14 | |
| A | * das ganze Dokument * ----- | 1,2,5-8 | |
| X | ABDENNADHER K ET AL: "Kalman filter used for on line monitoring and predictive maintenance system of aluminium electrolytic capacitors in UPS", ENERGY CONVERSION CONGRESS AND EXPOSITION, 2009. ECCE. IEEE, IEEE, PISCATAWAY, NJ, USA, 20. September 2009 (2009-09-20), Seiten 3188-3193, XP031887897, DOI: 10.1109/ECCE.2009.5316418 ISBN: 978-1-4244-2893-9 | 3,4,9-14 | RECHERCHIERTE SACHGEBIETE (IPC) |
| A | * das ganze Dokument * ----- -/-- | 1,2,5-8 | |

Der vorliegende Recherchenbericht wurde für alle Patentansprüche erstellt

| Recherchenort | Abschlußdatum der Recherche | Prüfer |
|---|---|---|
| München | 13. August 2012 | Bergado Colina, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

............................................................................

& : Mitglied der gleichen Patentfamilie, übereinstimmendes Dokument

EPO FORM 1503 03.82 (P04C03)

Europäisches
Patentamt

European
Patent Office

Office européen
des brevets

# EUROPÄISCHER RECHERCHENBERICHT

Nummer der Anmeldung

EP 12 15 8116

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | KARIM ABDENNADHER ET AL: "A Real-Time Predictive-Maintenance System of Aluminum Electrolytic Capacitors Used in Uninterrupted Power Supplies", IEEE TRANSACTIONS ON INDUSTRY APPLICATIONS, IEEE SERVICE CENTER, PISCATAWAY, NJ, US, Bd. 46, Nr. 4, 1. Juli 2010 (2010-07-01), Seiten 1644-1652, XP011313933, ISSN: 0093-9994 | 3,4,9-14 | |
| A | * das ganze Dokument * ----- | 1,2,5-8 | |
| X,D | DE 10 2004 052977 A1 (FORD GLOBAL TECH LLC [US]) 4. Mai 2006 (2006-05-04) | 3,9-14 | |
| A | * Zusammenfassung * * Seite 4, Absatz [0041] - Seite 6, Absatz [0068]; Abbildungen 1-9 * ----- | 1,2,4-8 | |
| X | JP 2006 078215 A (CHUBU ELECTRIC POWER) 23. März 2006 (2006-03-23) | 3,9-14 | |
| A | * Zusammenfassung; Abbildung 1 * ----- | 1,2,4-8 | RECHERCHIERTE SACHGEBIETE (IPC) |
| A,D | DE 10 2004 036211 A1 (SIEMENS AG [DE]) 23. März 2006 (2006-03-23) * Zusammenfassung * * Seite 3, Absatz [0016] - Seite 4, Absatz [0022]; Abbildung 1 * ----- | 1-14 | |
| A,D | DE 100 21 118 A1 (BAUMUELLER NUERNBERG GMBH [DE]) 8. November 2001 (2001-11-08) * Zusammenfassung * * Spalte 3, Absatz [0017] - Spalte 4, Absatz [0021]; Abbildungen 1-5 * ----- | 1-14 | |

Der vorliegende Recherchenbericht wurde für alle Patentansprüche erstellt

| Recherchenort | Abschlußdatum der Recherche | Prüfer |
|---|---|---|
| München | 13. August 2012 | Bergado Colina, J |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

................................................................

& : Mitglied der gleichen Patentfamilie, übereinstimmendes
   Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 12 15 8116

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-08-2012

| Im Recherchenbericht angeführtes Patentdokument | Datum der Veröffentlichung | Mitglied(er) der Patentfamilie | Datum der Veröffentlichung |
|---|---|---|---|
| US 2010161259 A1 | 24-06-2010 | CN 101842711 A<br>KR 20090023051 A<br>TW 200912329 A<br>US 2010161259 A1 | 22-09-2010<br>04-03-2009<br>16-03-2009<br>24-06-2010 |
| KR 20090105773 A | 07-10-2009 | KEINE | |
| JP 2002267708 A | 18-09-2002 | KEINE | |
| KR 20100120056 A | 12-11-2010 | KEINE | |
| JP 2008224533 A | 25-09-2008 | KEINE | |
| EP 2177923 A1 | 21-04-2010 | AT 498138 T<br>EP 2177923 A1<br>JP 2010097839 A | 15-02-2011<br>21-04-2010<br>30-04-2010 |
| JP 7222436 A | 18-08-1995 | KEINE | |
| DE 102004035723 A1 | 16-02-2006 | KEINE | |
| DE 102004052977 A1 | 04-05-2006 | KEINE | |
| JP 2006078215 A | 23-03-2006 | JP 4364754 B2<br>JP 2006078215 A | 18-11-2009<br>23-03-2006 |
| DE 102004036211 A1 | 23-03-2006 | KEINE | |
| DE 10021118 A1 | 08-11-2001 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004036211 A1
- DE 102004035723 A1
- DE 10021118 A1
- DE 102004052977 A1